# EUROPÄISCHE PATENTSCHRIFT

(11) **EP 3 016 225 B1**
(45) Veröffentlichungstag und Bekanntmachung des Hinweises auf die Patenterteilung: **07.09.2016**
(21) Anmeldenummer: 14191090.1
(22) Anmeldetag: 30.10.2014
(51) Int. Cl.: H02H 3/33, G01R 31/02, H02H 5/12, H02H 11/00, H02H 1/00

(54) **Erkennungsvorrichtung und Verfahren zur Erkennung von Fehlerzuständen eines Schutzleiters**
Detection device and method for detecting fault conditions in a protective circuit
Dispositif de reconnaissance et procédé de reconnaissance d'états défectueux d'un conducteur de mise à la terre

(43) Veröffentlichungstag der Anmeldung: 04.05.2016
(73) Patentinhaber: PC Electric Ges.m.b.H., 4973 St. Martin i.I. (AT)
(72) Erfinder: Froschauer, Josef, 4780 Schärding (AT); Irsigler, Thomas, 4780 Schärding (AT)
(74) Vertreter: KLIMENT & HENHAPEL

(56) Entgegenhaltungen:
- EP-A1- 0 751 600
- DE-A1- 3 151 261
- DE-A1-102011 081 950
- DE-U1-202014 101 858

## Beschreibung

Die vorliegende Erfindung betrifft eine Erkennungsvorrichtung zur Erkennung von Fehlerzuständen eines Schutzleiters eines Niederspannungsnetzes, die Erkennungsvorrichtung umfassend einen Schutzleiter zur Verbindung mit dem Schutzleiter des Niederspannungsnetzes, wobei in einem Betriebszustand der Erkennungsvorrichtung deren Schutzleiter mit dem Schutzleiter des Niederspannungsnetzes verbunden ist, wobei die Erkennungsvorrichtung einen ersten Leiter aufweist, um im Betriebszustand zwischen dem ersten Leiter und dem Schutzleiter der Erkennungsvorrichtung eine erste Spannung zur Verfügung zu stellen, wobei die Erkennungsvorrichtung einen Halbleiterschalter aufweist, der zwischen dem ersten Leiter und dem Schutzleiter der Erkennungsvorrichtung so geschaltet ist, dass beim Durchschalten des Halbleiterschalters Strom gegen den Schutzleiter abfließen kann, wobei die Erkennungsvorrichtung weiters einen Sensor mit einer Sensorfläche aus leitfähigem Material zur Berührung durch einen Benutzer aufweist, wobei der Sensor mit einer Steuerelektrode des Halbleiterschalters verbunden ist. Weiters betrifft die vorliegende Erfindung ein Verfahren zur Erkennung von Fehlerzuständen eines Schutzleiters, vorzugsweise eines Niederspannungsnetzes, das Verfahren umfassend das Verbinden eines Halbleiterschalters mit dem Schutzleiter.

### STAND DER TECHNIK

Der sichere Betrieb von elektrischen Betriebsmitteln, insbesondere von Elektrowerkzeugen bei Bau- und Montagearbeiten zu gewährleisten, ist eine Herausforderung, da insbesondere bei Baustellen fehlerhafte Elektroinstallationen nicht auszuschließen sind. Um die Sicherheit von Benutzern der elektrischen Betriebsmittel zu erhöhen, wird daher eine ortsveränderliche Fehlerstromschutzeinrichtung (manchmal auch als "portable residual current device" oder einfach als "PRCD" bezeichnet) an das über die vorhandenen Elektroinstallationen zur Verfügung gestellte Niederspannungsnetz angeschlossen. Die elektrischen Betriebsmittel, insbesondere Elektrowerkzeuge werden dann an die ortsveränderliche Fehlerstromschutzeinrichtung - und nicht direkt an das Niederspannungsnetz - angeschlossen. Als Niederspannungsnetz wird dabei ein Wechselstromnetz mit einer effektiven Spannung von typischerweise 130 V bis 1000 V, insbesondere von 230 V bis 400 V verstanden.

Aus der EP 0806825 B1 ist eine ortsveränderliche Fehlerstromschutzeinrichtung bekannt, welche neben Fehlerströmen auch Fehlerzustände des Schutzleiters des Niederspannungsnetzes, im Folgenden auch als PE-Leiter bezeichnet, feststellen kann. Dabei wird zum einen überprüft, ob als Fehlerzustand ein nicht angeschlossener oder unterbrochener PE-Leiter vorliegt. Hierzu ist ein Spannungsteiler vorgesehen, der an einem Mittelpunkt die halbe Spannung zwischen einem Phasenleiter (im Folgenden auch als L-Leiter bezeichnet) und einem Nullleiter (im Folgenden auch als N-Leiter bezeichnet) des Niederspannungsnetzes zur Verfügung stellt. Über eine Leuchtdiode eines Optokopplers ist dieser Mittelpunkt mit dem PE-Leiter verbunden. Bei niederohmig angeschlossenem Schutzleiter fließt im Betrieb ein Strom durch die LED und signalisiert diesen - fehlerfreien - Zustand einer zugehörigen Steuereinheit.

Zum anderen wird das korrekte Potential des PE-Leiters gegenüber dem lokalen Erdpotential des Benutzers überprüft. Hintergrund dieser zweiten Prüfung ist der mögliche Fehlerzustand, dass in einer Steckdose der vorhandenen Elektroinstallation der PE-Leiter in Folge einer fehlerhaften Installation mit dem L-Leiter verbunden sein könnte. Gemäß EP 0806825 B1 erfolgt diese Überprüfung so, dass der hochohmige Steuereingang eines Feldeffekt-Transistors über eine Schutzschaltung mit einer leitenden Sensorfläche verbunden ist. Diese Sensorfläche ist Teil einer Einschalttaste, welche der Benutzer mit seiner Hand betätigt und derart sein lokales Erdpotential anlegt. Das Ruhepotential an diesem Eingang wird über einen Widerstand auf das Bezugspotential des Transistors, d.h. auf den PE-Leiter, gelegt. Der Transistor ist dadurch im Aus-Zustand, was dem Zustand "kein Fehler" entspricht.

Eine Spannung zwischen PE-Leiter und dem lokalen Erdpotential des Benutzers, die durch eine Fehlerspannung, insbesondere Phasenspannung auf dem PE-Leiter hervorgerufen werden kann, führt bei Berühren der Sensorfläche zu einem Einschalten des Transistors. Der leitende Transistor schließt die Leuchtdiode des Optokopplers kurz, sodass die Leuchtdiode des Optokopplers nicht mehr leuchtet, wodurch ein Fehlerzustand an die Steuereinheit signalisiert wird.

Ein großer Nachteil dieses Verfahrens ist, dass eine Betätigung des Einschalters bzw. eine Berührung der Sensorfläche mit einem isolierten Gegenstand (Handschuhe) diese Schutzfunktion unwirksam macht. Dies ist z.B. dann der Fall, wenn der Benutzer die Einschalttaste mit Gummihandschuhen betätigt. Es besteht dann kein klar erkennbarer Unterschied zwischen einem korrekten lokalen Erdpotential und einer unzureichend leitenden Verbindung zwischen Sensorfläche und dem Benutzer. Dies kann dazu führen, dass eine vorhandene fehlerhafte Installation, bei welcher der PE-Leiter z.B. mit dem L-Leiter verbunden ist, nicht erkannt wird und die ortsveränderliche Fehlerstromschutzeinrichtung trotzdem ein Einschalten erlauben würde, was wiederum eine erhebliche Gefährdung des Benutzers nach sich zieht.

### AUFGABE DER ERFINDUNG

Es ist daher Aufgabe er vorliegenden Erfindung eine Vorrichtung und ein Verfahren zur Verfügung zu stellen, welche die Erkennung von Fehlerzuständen eines Schutzleiters ermöglichen und die oben genannten Nachteile vermeiden. Insbesondere soll eine Fehlerspannung am Schutzleiter zuverlässig erkannt werden.

### DARSTELLUNG DER ERFINDUNG

Kern der Erfindung ist es, ein Prüfpotential aktiv an die Sensorfläche anzulegen, um auch die Berührung der Sensorfläche mit einem isolierten Gegenstand als Fehler erkennen zu können. Dieses Prüfpotential stammt aus einer hochohmigen Spannungsquelle und wird vom Benutzer bei Berührung auf dessen lokales Erdpotential gelegt. Der Innenwiderstand der Spannungsquelle und die Impedanz des Benutzers von Sensorfläche bis zu seinem lokalen Erdpotential bilden einen Spannungsteiler, dessen Ausgang mit einer Steuerelektrode eines Halbleiterschalters verbunden ist. Der Halbleiterschalter wiederum ist mit dem Schutzleiter des Niederspannungsnetzes verbunden. Weiters liegt am Halbleiterschalter eine erste Spannung an. Bei korrekten Erdungsverhältnissen ist die Spannung an der Steuerelektrode - genauer, zwischen Steuerelektrode und dem Schutzleiter des Niederspannungsnetzes - so gering, dass der Halbleiterschalter nicht schaltet. Wenn es sich um einen normal sperrenden Halbleiterschalter handelt, bedeutet dies, dass der Halbleiterschalter nicht durchschaltet und trotz der ersten Spannung kein Strom durch den Halbleiterschalter fließt. Bei einem normal leitenden Halbleiterschalter hingegen, würde in diesem Fall Strom durch Halbleiterschalter fließen, da dieser weiterhin durchschalten würde.

Bei falschen Erdungsverhältnissen, sei es dass am Schutzleiter des Niederspannungsnetzes eine Fehlerspannung, insbesondere Phasenspannung anliegt oder dass der Benutzer die Sensorfläche mit einem isolierenden Gegenstand berührt, ist die Spannung am Ausgang des Spannungsteilers so hoch, dass zwischen der Steuerelektrode und dem Schutzleiter des Niederspannungsnetzes eine Spannung anliegt, die höher als eine Schwellspannung des Halbleiterschalters ist, sodass der Halbleiterschalter schaltet. Wenn es sich um einen normal sperrenden Halbleiterschalter handelt, bedeutet dies, dass der Halbleiterschalter durchschaltet und aufgrund der ersten Spannung dann Strom durch den Halbleiterschalter fließt. Bei einem normal leitenden Halbleiterschalter hingegen, würde in diesem Fall kein Strom durch Halbleiterschalter fließen, da dieser nicht mehr durchschalten würde.

Indem also detektiert wird, ob der Halbleiterschalter schaltet oder nicht, kann zuverlässig ermittelt werden, ob Fehlerzustände in Form einer Fehlerspannung am Schutzleiter des Niederspannungsnetzes und/oder in Form der Berührung der Sensorfläche mit einem isolierten Gegenstand vorliegen oder ob kein Fehler vorliegt, also korrekte Erdungsverhältnisse gegeben sind. Die erste Spannung vereinfacht diese Detektion, da das Durchschalten mit einem Stromfluss verbunden ist und daher lediglich detektiert werden muss, ob Strom fließt oder nicht.

Es könnte jedoch prinzipiell auch lediglich die Spannung zwischen der Steuerelektrode und dem Schutzleiter des Niederspannungsnetzes detektiert werden bzw. ob diese Spannung größer als eine bestimmte Spannung, wie z.B. die Schwellspannung des Halbleiterschalters, ist.

Daher ist es bei einer Erkennungsvorrichtung zur Erkennung von Fehlerzuständen eines Schutzleiters eines Niederspannungsnetzes, die Erkennungsvorrichtung umfassend einen Schutzleiter zur Verbindung mit dem Schutzleiter des Niederspannungsnetzes, wobei in einem Betriebszustand der Erkennungsvorrichtung deren Schutzleiter mit dem Schutzleiter des Niederspannungsnetzes verbunden ist, wobei die Erkennungsvorrichtung einen ersten Leiter aufweist, um im Betriebszustand zwischen dem ersten Leiter und dem Schutzleiter der Erkennungsvorrichtung eine erste Spannung zur Verfügung zu stellen, wobei die Erkennungsvorrichtung einen Halbleiterschalter aufweist, der zwischen dem ersten Leiter und dem Schutzleiter der Erkennungsvorrichtung geschaltet ist, wobei die Erkennungsvorrichtung weiters einen Sensor mit einer Sensorfläche aus leitfähigem Material zur Berührung durch einen Benutzer aufweist, wobei der Sensor mit einer Steuerelektrode des Halbleiterschalters sowie mit dem Schutzleiter der Erkennungsvorrichtung verbunden ist, erfindungsgemäß vorgesehen, dass die Erkennungsvorrichtung einen zweiten Leiter aufweist, der mit der Sensorfläche verbunden ist, um im Betriebszustand an die Sensorfläche ein Prüfpotential anzulegen, um bei Berührung der Sensorfläche durch den auf einem lokalen Erdpotential befindlichen Benutzer einen Spannungsteiler zu bilden, dessen Ausgang eine Impedanz des Benutzers umfasst und mit der Steuerelektrode des Halbleiterschalters verbunden ist, und dass die Erkennungsvorrichtung derart ausgelegt ist, dass im Betriebszustand und bei angelegtem Prüfpotential bei Berührung der Sensorfläche mit einem isolierenden Gegenstand und/oder bei Berührung der Sensorfläche und Vorliegen einer Fehlerspannung, insbesondere Phasenspannung, am Schutzleiter des Niederspannungsnetzes eine zwischen der Steuerelektrode des Halbleiterschalters und dem Schutzleiter der Erkennungsvorrichtung anliegende Spannung den Halbleiterschalter schaltet, um die Berührung der Sensorfläche mit dem isolierenden Gegenstand und/oder die Fehlerspannung, insbesondere Phasenspannung, am Schutzleiter des Niederspannungsnetzes als Fehlerzustände erkennen zu können. Dabei wird natürlich auch dann ein Fehler detektiert, wenn eine Fehlerspannung, insbesondere Phasenspannung am Schutzleiter der Erkennungsvorrichtung anliegt bzw. liegt im Betriebszustand auch am Schutzleiter der Erkennungsvorrichtung eine Fehlerspannung an, wenn diese am Schutzleiter des Niederspannungsnetzes anliegt.

Das Berühren des Sensors bzw. der leitenden Sensorfläche mit einem isolierenden Gegenstand bewirkt im Vergleich zur direkten Berührung durch den Benutzer eine Vervielfachung der Impedanz des Benutzers, sodass in diesem Fall das Teilungsverhältnis der Spannungen auf mindestens 1:10, vorzugsweise auf mindestens 1:100 anwächst. Das bedeutet, dass die am Benutzer abfallende Spannung mindestens 10 mal, vorzugsweise mindestens 100 mal größer ist als die am anderen Teil des Spannungsteilers abfallende Spannung. Dabei ist die Impedanz des Benutzers, der die leitende Sensorfläche mit einem isolierenden Gegenstand, z.B. mit Gummihandschuhen, einem trockenen Holzstab oder einem trockenen Glasstab, berührt, üblicherweise mindestens bzw. größer gleich 10 MΩ, bevorzugt größer gleich 20 MΩ, besonders bevorzugt größer gleich 50 MΩ. Es sei bemerkt, dass sich diese Impedanz bzw. dieser Wechselstromwiderstand im Wesentlichen aus kapazitiven und ohmschen Anteilen zusammensetzt.

Weiters sei bemerkt, dass die Erkennungsvorrichtung unabhängig davon funktioniert, ob das Niederspannungsnetz eine Phase oder drei Phasen zur Verfügung stellt. Entsprechend kann es vorgesehen sein, dass die Erkennungsvorrichtung eingangsseitig nicht nur mit dem Schutzleiter des Niederspannungsnetzes, sondern auch mit einem oder mehreren Phasenleitern des Niederspannungsnetzes und auch mit einem Nullleiter des Niederspannungsnetzes verbindbar ist.

Analog ist es bei einem Verfahren zur Erkennung von Fehlerzuständen eines Schutzleiters, vorzugsweise eines Niederspannungsnetzes, das Verfahren umfassend das Verbinden eines Halbleiterschalters mit dem Schutzleiter, erfindungsgemäß vorgesehen, dass das Verfahren die folgenden Schritte umfasst:
- Anlegen eines Prüfpotentials an eine leitende Sensorfläche eines Sensors, der mit einer Steuerelektrode des Halbleiterschalters verbunden ist;
- Berührung der Sensorfläche durch einen auf einem lokalen Erdpotential befindlichen Benutzer, wobei ein Spannungsteiler gebildet wird, dessen Ausgang eine Impedanz des Benutzers umfasst und mit der Steuerelektrode des Halbleiterschalters verbunden ist;
- Detektion, ob die Berührung der Sensorfläche mit einem isolierenden Gegenstand erfolgt und/oder ob bei Berührung der Sensorfläche eine Fehlerspannung, insbesondere Phasenspannung, am Schutzleiter anliegt, indem detektiert wird, ob der Halbleiterschalter schaltet.

Wie erwähnt, wird die Detektion des Schaltens erleichtert, wenn das Durchschalten mit einem Strom, der durch den Halbleiterschalter gegen den Schutzleiter abfließt, verbunden ist. Entsprechend ist es bei einer bevorzugten Ausführungsform des erfindungsgemäßen Verfahrens vorgesehen, dass an den Halbleiterschalter eine erste Spannung angelegt wird, um einen gegen den Schutzleiter abfließenden Strom zu erzeugen, wenn der Halbleiterschalter durchschaltet.

Um die Größe der an der Steuerelektrode anliegenden Spannung im Gegensatz zur Spannung am Ausgang des Spannungsteilers zu verringern bzw. an die Schwellspannung des Halbleiterschalters anzupassen, ist es bei einer bevorzugten Ausführungsform der erfindungsgemäßen Erkennungsvorrichtung vorgesehen, dass zur Verbindung des Ausgangs des Spannungsteilers mit der Steuerelektrode des Halbleiterschalters ein weiterer Spannungsteiler vorgesehen ist, dessen Ausgang mit der Steuerelektrode des Halbleiterschalters verbunden ist.

D.h. der weitere Spannungsteiler ist dem Ausgang des Spannungsteilers nachgeschaltet. Dies ermöglicht es, auch Halbleiterschalter mit einer relativ geringen Schwellspannung von z.B. 2 V bis 3 V zu verwenden.

Analog ist es daher bei einer bevorzugten Ausführungsform des erfindungsgemäßen Verfahrens vorgesehen, dass eine zur Ansteuerung der Steuerelektrode des Halbleiterschalters verwendete Spannung gegenüber einer Spannung am Ausgang des Spannungsteilers reduziert wird, vorzugsweise mittels eines weiteren Spannungsteilers, dessen Ausgang mit der Steuerelektrode des Halbleiterschalters verbunden ist.

Um die an der Steuerelektrode des Halbleiterschalters anliegende Spannung zu begrenzen und so Beschädigungen des Halbleiterschalters zu vermeiden, ist es bei einer bevorzugten Ausführungsform der erfindungsgemäßen Erkennungsvorrichtung vorgesehen, dass zwischen der Steuerelektrode des Halbleiterschalters und dem Schutzleiter der Erkennungsvorrichtung eine Zener-Diode geschaltet ist.

Analog ist es daher bei einer bevorzugten Ausführungsform des erfindungsgemäßen Verfahrens vorgesehen, dass eine zur Ansteuerung der Steuerelektrode des Halbleiterschalters verwendete Spannung begrenzt wird, vorzugsweise mittels einer Zener-Diode, die zwischen der Steuerelektrode des Halbleiterschalters und dem Schutzleiter geschaltet ist.

Weiters kann zur Verbesserung der elektromagnetischen Verträglichkeit ein Kondensator vorgesehen sein, der zwischen der Steuerelektrode des Halbleiterschalters und dem Schutzleiter der Erkennungsvorrichtung geschaltet ist. Vorzugsweise weist dieser Kondensator eine geringe Kapazität zwischen 0,1 nF und 10 nF auf.

Um die erste Spannung auf einfache Art und Weise zur Verfügung stellen zu können bzw. um auf einfache Art und Weise eine erste Spannungsquelle für die Bereitstellung der ersten Spannung erzeugen zu können, ist es bei einer bevorzugten Ausführungsform der erfindungsgemäßen Erkennungsvorrichtung vorgesehen, dass die Erkennungsvorrichtung einen Phasenleiter zur Verbindung mit einem Phasenleiter des Niederspannungsnetzes sowie einen Nullleiter zur Verbindung mit einem Nullleiter des Niederspannungsnetzes aufweist, wobei im Betriebszustand der Erkennungsvorrichtung deren Phasenleiter mit dem Phasenleiter oder dem Nullleiter des Niederspannungsnetzes verbunden ist und der Nullleiter der Erkennungsvorrichtung mit dem Nullleiter oder dem Phasenleiter des Niederspannungsnetzes, dass weiters zwischen dem Phasenleiter der Erkennungsvorrichtung und dem Nullleiter der Erkennungsvorrichtung mindestens zwei Widerstände in Serie geschaltet sind und dass der erste Leiter mit einem Punkt zwischen den mindestens zwei Widerständen verbunden ist. D.h. die mindestens zwei Widerstände bilden einen Spannungsteiler zwischen dem Nullleiter und dem Phasenleiter der Erkennungsvorrichtung, an dessen Ausgang die erste Spannung gegenüber dem Schutzleiter der Erkennungsvorrichtung anliegt.

Um auf eine einfache Art und Weise eine zweite Spannungsquelle zu erzeugen, über welche das Prüfpotential zur Verfügung gestellt werden kann, ist es bei einer bevorzugten Ausführungsform der erfindungsgemäßen Erkennungsvorrichtung vorgesehen, dass die Erkennungsvorrichtung einen Phasenleiter zur Verbindung mit einem Phasenleiter des Niederspannungsnetzes sowie einen Nullleiter zur Verbindung mit einem Nullleiter des Niederspannungsnetzes aufweist, wobei im Betriebszustand der Erkennungsvorrichtung deren Phasenleiter mit dem Phasenleiter oder dem Nullleiter des Niederspannungsnetzes verbunden ist und der Nullleiter der Erkennungsvorrichtung mit dem Nullleiter oder dem Phasenleiter des Niederspannungsnetzes, dass weiters zwischen dem Phasenleiter der Erkennungsvorrichtung und dem Nullleiter der Erkennungsvorrichtung mindestens zwei weitere Widerstände in Serie geschaltet sind und dass der zweite Leiter mit einem Punkt zwischen den mindestens zwei weiteren Widerständen verbunden ist.

Eine einfache und kostengünstige Realisierung des Halbleiterschalters ist die Verwendung eines Feldeffekttransistors, wie beispielsweise eines MOSFET. Diese sind sowohl als normal leitend als auch als normal sperrend verfügbar. Zudem kann auf Feldeffekttransistoren mit unterschiedlichsten Schwellspannungen zurückgegriffen werden. Daher ist es bei einer bevorzugten Ausführungsform der erfindungsgemäßen Erkennungsvorrichtung vorgesehen, dass der Halbleiterschalter ein Feldeffekttransistor ist. Grundsätzlich wären aber natürlich auch andere Halbleiterschalter, wie z.B. ein Triac möglich.

Um das Durchschalten des Halbleiterschalters auf einfache Art und Weise erkennen zu können, ist es bei einer bevorzugten Ausführungsform der erfindungsgemäßen Erkennungsvorrichtung vorgesehen, dass die Erkennungsvorrichtung eine Potentialtrennstufe aufweist, deren Eingang parallel zum Halbleiterschalter geschaltet ist. Der Eingang der Potentialtrennstufe wird durch den Halbleiterschalter kurzgeschlossen, wenn der Halbleiterschalter durchschaltet, was die Detektion des Durchschaltens vereinfacht, da dann über den Eingang der Potentialtrennstufe kein Strom fließt und entsprechend auch am Ausgang der Potentialtrennstufe kein Strom fließt bzw. zwischen Eingang und Ausgang der Potentialtrennstufe kein Signal übertragen wird. Entsprechend braucht also lediglich der Ausgang der Potentialtrennstufe überwacht zu werden.

Weiters kann mittels der Potentialtrennstufe leicht ein weiterer Fehlerzustand erkannt werden, nämlich dass der Schutzleiter des Niederspannungsnetzes nicht verbunden oder unterbrochen ist. Auch in diesem Fall kann über den Eingang der Potentialtrennstufe kein Strom gegen den Schutzleiter der Erkennungsvorrichtung bzw. des Niederspannungsnetzes abfließen, und es kommt kein Signal am Ausgang der Potentialtrennstufe an. Natürlich wird auf diese Art und Weise auch eine Unterbrechung des Schutzleiters der Erkennungsvorrichtung detektiert.

Analog ist es daher bei einer bevorzugten Ausführungsform des erfindungsgemäßen Verfahrens vorgesehen, dass zur Detektion, ob der Halbleiter durchschaltet oder nicht, eine Potentialtrennstufe verwendet wird, deren Eingang parallel zum Halbleiterschalter geschaltet ist und kurzgeschlossen wird, wenn der Halbleiterschalter durchschaltet. Bzw. ist es bei einer besonders bevorzugten Ausführungsform des erfindungsgemäßen Verfahrens vorgesehen, dass mittels der Potentialtrennstufe außerdem detektiert wird, ob der Schutzleiter nicht verbunden oder unterbrochen ist, indem bei ausgeschaltetem Prüfpotential detektiert wird, dass über den Eingang der Potentialtrennstufe kein Strom zum Schutzleiter abfließt.

Als Potentialtrennstufen können prinzipiell unterschiedliche potentialtrennende Bauteile verwendet werden, wie beispielsweise Triac-Koppler, Opto-Feldeffekttransistoren, Piezokoppler, Übertrager oder Relais. Um eine besonders einfache und kostengünstige Lösung zur Verfügung zu stellen, ist es bei einer bevorzugten Ausführungsform der erfindungsgemäßen Erkennungsvorrichtung vorgesehen, dass die Potentialtrennstufe ein Optokoppler ist. In diesem Fall bildet eine Leuchtdiode des Optokopplers den Eingang der Potentialtrennstufe bzw. ist die Leuchtdiode des Optokopplers zwischen dem ersten Leiter und dem Schutzleiter der Erkennungsvorrichtung geschaltet. Das Durchschalten des Halbleiterschalters bewirkt, dass die Leuchtdiode des Optokopplers nicht leuchtet.

Um einen Selbsttest der gesamten Sensorik zu ermöglichen, ist es bei einer bevorzugten Ausführungsform der erfindungsgemäßen Erkennungsvorrichtung vorgesehen, dass ein Schalter mit dem zweiten Leiter und dem Schutzleiter der Erkennungsvorrichtung verbunden ist, um im Betriebszustand durch Ein-/Ausschalten des Schalters den zweiten Leiter mit dem Schutzleiter der Erkennungsvorrichtung kurzzuschließen / den Kurzschluss aufzuheben, um das Prüfpotential aus-/einzuschalten und somit die Funktion der Erkennungsvorrichtung überprüfen zu können. So kann beispielsweise bei Herstellung des Betriebszustands der Erkennungsvorrichtung der Schalter ausgeschaltet und damit das Prüfpotential angelegt sein. Wird dann die Fehlerüberprüfung durchgeführt, indem der Benutzer die Sensorfläche berührt, und wird kein Fehler detektiert, kann der Schalter eingeschaltet und das Prüfpotential ausgeschaltet werden. Vorzugsweise handelt es sich bei dem Schalter um einen elektronischen Schalter.

Sodann kann während des Betriebs in regelmäßigen Abständen - von Millisekunden bis Stunden ist prinzipiell alles möglich - der Schalter kurz aus- und wieder eingeschaltet werden. Sollte dann, ohne dass der Benutzer die Sensorfläche berührt, trotz ausgeschaltetem Schalter der Halbleiterschalter nicht durchschalten, zeigt dies einen Fehler an. Ein solcher Fehler könnte beispielsweise durch einen defekten Halbleiterschalter verursacht werden, der z.B. immer sperrt. Die Information, dass ein Fehler vorliegt, kann dazu benutzt werden, die Stromversorgung von elektrischen Betriebsmitteln zu unterbrechen.

Zur Überwachung und Auswertung bzw. Fehlerdetektion ist es bei einer bevorzugten Ausführungsform der erfindungsgemäßen Erkennungsvorrichtung vorgesehen, dass eine Steuereinheit vorgesehen ist, die eingangsseitig mit dem Ausgang der Potentialtrennstufe verbunden ist.

Die Steuereinheit kann auch dazu verwendet werden, in regelmäßigen Abständen Selbsttests der Sensorik durchzuführen, indem die Steuereinheit den Schalter z.B. in der oben beschriebenen Weise ansteuert. Daher ist es bei einer bevorzugten Ausführungsform der erfindungsgemäßen Erkennungsvorrichtung vorgesehen, dass die Steuereinheit mit dem Schalter verbunden ist und dieser mit der Steuereinheit steuerbar ist.

Um eine sichere Stromversorgung von elektrischen Betriebsmitteln, insbesondere auf Baustellen, mittels einer ortsveränderlichen Fehlerstromschutzeinrichtung gewährleisten zu können, ist erfindungsgemäß eine ortsveränderliche Fehlerstromschutzeinrichtung umfassend eine erfindungsgemäße Erkennungseinrichtung vorgesehen.

Schließlich ist für die sichere Stromversorgung von elektrischen Betriebsmitteln, insbesondere auf Baustellen, erfindungsgemäß ein System zur lokalen Bereitstellung von Wechselstrom vorgesehen, umfassend einen Phasenleiter eines Niederspannungsnetzes, einen Nullleiter des Niederspannungsnetzes sowie einen Schutzleiter des Niederspannungsnetzes, das System weiters umfassend eine erfindungsgemäße Erkennungsvorrichtung oder eine erfindungsgemäße ortsveränderliche Fehlerstromschutzeinrichtung, wobei ein Phasenleiter der Erkennungsvorrichtung mit dem Phasenleiter oder dem Nullleiter des Niederspannungsnetzes verbunden ist, wobei weiters ein Nullleiter der Erkennungsvorrichtung mit dem Nullleiter oder dem Phasenleiter des Niederspannungsnetzes verbunden ist und wobei der Schutzleiter der Erkennungsvorrichtung mit dem Schutzleiter des Niederspannungsnetzes verbunden ist.

### KURZE BESCHREIBUNG DER FIGUREN

Die Erfindung wird nun anhand von Ausführungsbeispielen näher erläutert. Die Zeichnungen sind beispielhaft und sollen den Erfindungsgedanken zwar darlegen, ihn aber keinesfalls einengen oder gar abschließend wiedergeben.

Dabei zeigt:
- Fig. 1: eine Schaltskizze einer erfindungsgemäßen Erkennungsvorrichtung welche an ein Niederspannungsnetz angeschlossen ist
- Fig. 2: eine schematische Darstellung einer ortsveränderlichen Fehlerstromschutzeinrichtung mit einer erfindungsgemäßen Erkennungsvorrichtung

### WEGE ZUR AUSFÜHRUNG DER ERFINDUNG

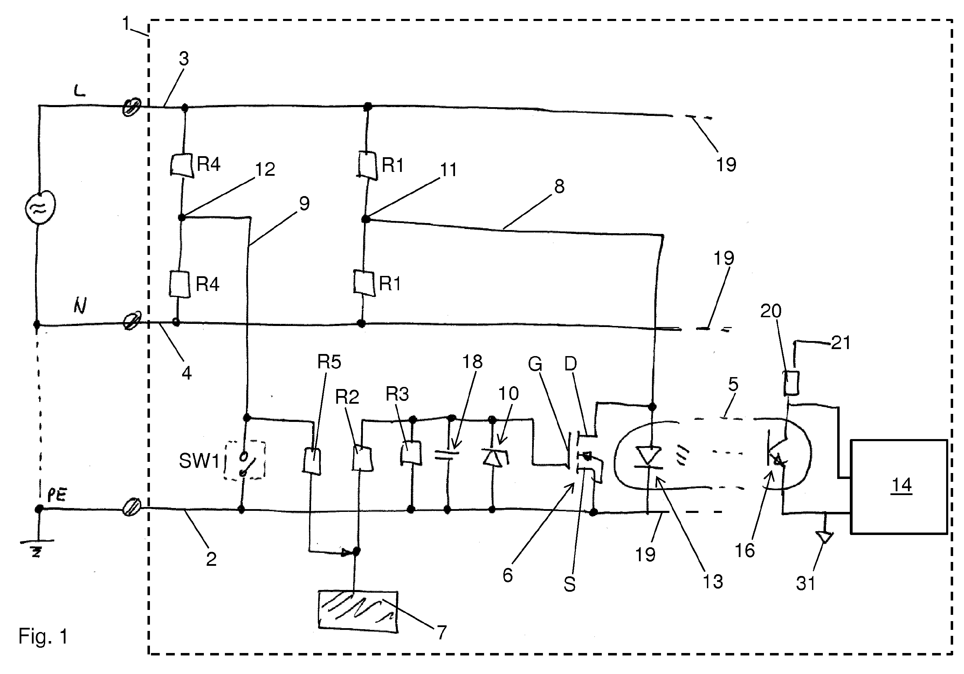

Fig. 1 zeigt eine Schaltskizze einer erfindungsgemäßen Erkennungsvorrichtung 1, welche zur Durchführung eines erfindungsgemäßen Verfahrens zur Erkennung von Fehlerzuständen eines Schutzleiters, insbesondere eines Schutzleiters PE eines Niederspannungsnetzes geeignet ist. Das Niederspannungsnetz weist außerdem mindestens einen Phasenleiter L sowie einen Nullleiter N auf. Im gezeigten Ausführungsbeispiel sind der Schutzleiter PE, der Phasenleiter L und der Nullleiter N eingangsseitig mit der Erkennungsvorrichtung 1 verbunden, sodass sich diese in einem Betriebszustand befindet.

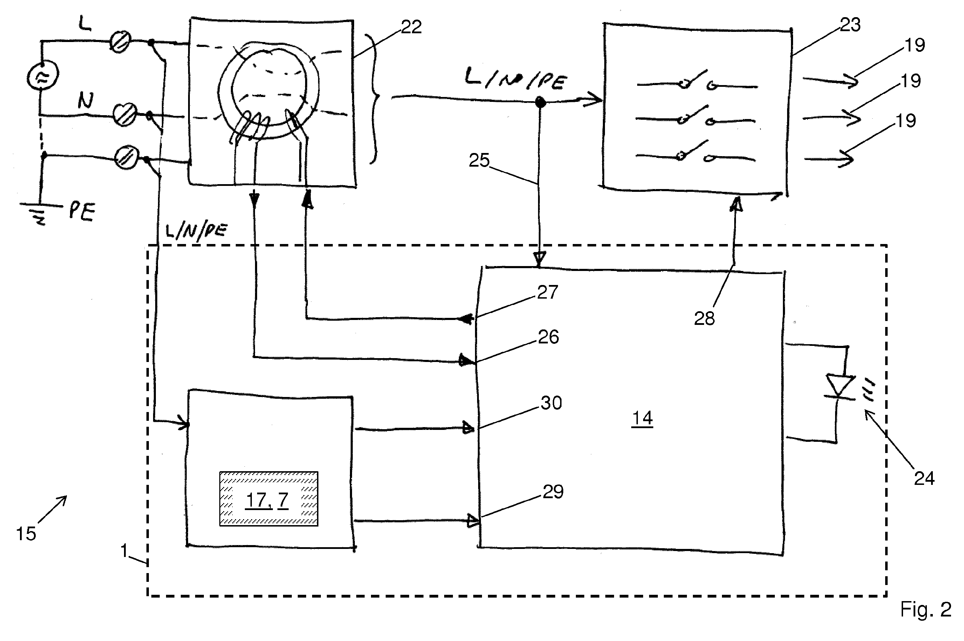

Generell ist im Betriebszustand der Erkennungsvorrichtung 1 zumindest ein Schutzleiter 2 der Erkennungsvorrichtung 1 mit dem Schutzleiter PE verbunden. Im Ausführungsbeispiel der Fig. 1 ist im Betriebszustand außerdem ein Phasenleiter 3 der Erkennungsvorrichtung 1 mit dem Phasenleiter L oder dem Nullleiter N verbunden. Weiters ist im Ausführungsbeispiel der Fig. 1 im Betriebszustand außerdem ein Nullleiter 4 der Erkennungsvorrichtung 1 mit dem Nullleiter N oder dem Phasenleiter L verbunden. Hintergrund der möglichen Vertauschung der Anschlüsse der Leiter L und N ist, dass bei einem Einsatz der Erkennungsvorrichtung 1 in einer ortsveränderlichen Fehlerstromschutzeinrichtung 15 (vgl. Fig. 2) letztere üblicherweise mit einer Steckdose des vor Ort vorhandenen Niederspannungsnetzes verbunden wird. Diese Verbindung erfolgt mit einem Schutzkontaktstecker, der zwei, um 180° relativ zueinander verdrehte Positionen zulässt, sodass a priori unklar ist, ob der Phasenleiter 3 mit dem Phasenleiter L oder dem Nullleiter N verbunden wird und der Nullleiter 4 mit dem Nullleiter N oder dem Phasenleiter L.

Die Erkennungsvorrichtung 1 bietet wie bekannte Systeme die Möglichkeit zu überprüfen, ob der Schutzleiter PE fälschlicherweise nicht angeschlossen oder unterbrochen ist. Hierzu sind im gezeigten Ausführungsbeispiel zunächst ein Spannungsteiler aus zwei Vorwiderstände R1 vorgesehen, die in Serie zwischen dem Phasenleiter 3 und dem Nullleiter 4 geschaltet sind. Indem die Vorwiderstände R1 gleich groß sind, beispielsweise jeder Vorwiderstand R1 470 kΩ, wird am Mittelpunkt bzw. Anschlusspunkt 11 eine erste Spannungsquelle für eine erste Spannung geschaffen, die halb so groß wie die Phasenspannung des Niederspannungsnetzes ist. Bei einer Phasenspannung von beispielsweise 230 V wäre die erste Spannung also 115 V groß. Der Innenwiderstand der ersten Spannungsquelle ist ½ R1.

Der Eingang eines Optokopplers 5 ist zwischen einem ersten Leiter 8 und dem Schutzleiter 2 geschaltet. Da der erste Leiter 8 mit dem Anschlusspunkt 11 verbunden ist, liegt am Eingang des Optokopplers 5 also die erste Spannung an. Der Eingang des Optokopplers 5 umfasst eine Leuchtdiode 13. Im Betriebszustand kann über die Leuchtdiode 13 bei jeder zweiten Halbwelle prinzipiell Strom fließen, wenn der Schutzleiter PE niederohmig angeschlossen und nicht unterbrochen ist, sodass die Leuchtdiode 13 bei jeder zweiten Halbwelle des Wechselstroms leuchtet. Somit kann dann auch entsprechend Strom über einen den Ausgang des Optokopplers 5 bildenden Fototransistor 16 bzw. über dessen Kollektor-Emitter-Strecke fließen bzw. kann am Ausgang des Optokopplers 5 ein entsprechendes Signal, das einem Blinken, beispielsweise in Form einer Rechteckschwingung oder einer Dreieckschwingung, entspricht, mittels einer Steuereinheit 14 detektiert werden. Zur Spannungs- bzw. Stromversorgung des Fototransistors 16 sind ein Anschluss 21 sowie ein Referenzpotential 31 vorgesehen, zwischen denen der Fototransistor 16 geschaltet ist. Dabei ist dem Fototransistor 16 ein Vorwiderstand 20, der beispielsweise 47 kΩ groß sein kann, vorgeschaltet. Mittels der Steuereinheit 14 wird die am Fototransistor 16 abfallende Spannung bzw. deren zeitlicher Verlauf detektiert.

Ist jedoch der Schutzleiter PE - oder auch der Schutzleiter 2 - unterbrochen oder gar nicht angeschlossen, kann kein Strom über die Leuchtdiode 13 fließen. Entsprechend wird am Ausgang des Optokopplers 5 auch kein Signal detektiert bzw. fließt über den Fototransistor 16 grundsätzlich kein Strom, was als Fehlerzustand interpretiert werden kann.

Zur Überprüfung, ob am Schutzleiter PE eine Fehlerspannung, insbesondere Phasenspannung anliegt, wird mittels der in Fig. 1 dargestellten Erkennungsvorrichtung 1 ein erfindungsgemäßes Verfahren durchgeführt. Hierzu ist ein Sensor 7 mit einer leitenden Sensorfläche vorgesehen, an welche ein Prüfpotential gelegt wird. Insbesondere wenn die Erkennungsvorrichtung 1 Teil einer Fehlerstromschutzeinrichtung 15 ist, ist es vorteilhaft, wenn die Sensorfläche Teil eines Einschaltknopfs bzw. einer Einschalttaste 17 (vgl. Fig. 2) ist.

Zur Erzeugung des Prüfpotentials weist die Erkennungsvorrichtung 1 im gezeigten Ausführungsbeispiel eine zweite Spannungsquelle auf, die durch einen Spannungsteiler aus den weiteren Vorwiderständen R4 gebildet ist. Die weiteren Vorwiderstände R4 können dabei beispielsweise jeweils 470 kΩ groß sein. Indem die weiteren Vorwiderstände R4 gleich groß und in Serie zwischen dem Phasenleiter 3 und dem Nullleiter 4 geschaltet sind, wird die Spannung zwischen dem Phasenleiter 3 und dem Nullleiter 4 im Mittelpunkt bzw. Anschlusspunkt 12 halbiert.

Ein zweiter Leiter 9 ist am Anschlusspunkt 12 angeschlossen und über einen weiteren Schutzwiderstand R5 mit dem Sensor 7 bzw. der Sensorfläche verbunden. Der weitere Schutzwiderstand R5 kann beispielsweise 10 MΩ groß sein. Das Prüfpotential wird also durch eine Spannungsquelle zur Verfügung gestellt, deren Innenwiderstand ½ R4 + R5 beträgt. Wenn ein auf einem lokalen Erdpotential befindlicher Benutzer die Sensorfläche berührt, bilden dieser Innenwiderstand und die Impedanz des Benutzers von der Sensorfläche bis zu seinem lokalen Erdpotential einen Spannungsteiler. Der Ausgang dieses Spannungsteilers liegt über einen weiteren Spannungsteiler am Eingang eines normal sperrenden MOSFET 6 an, der mit seinem Drain D und seiner Source S parallel zum Eingang des Optokopplers 5 geschaltet ist. Dabei ist der weitere Spannungsteiler aus einem Schutzwiderstand R2 von beispielsweise 4,7 MΩ und einem Widerstand R3 von beispielsweise 1 MΩ aufgebaut, die in Serie zwischen dem Sensor 7 bzw. der Sensorfläche und dem Schutzleiter 2 geschaltet sind. R3 bildet den Ausgang des weiteren Spannungsteilers. D.h. eine Spannung am Ausgang R3 des weiteren Spannungsteilers liegt zwischen der Steuerelektrode bzw. dem Gate G des MOSFET 6 und dem Schutzleiter 2 bzw. der Source S des MOSFET 6 an.

Um Beschädigungen des MOSFET 6 durch zu hohe Spannungen zu vermeiden ist eine Zener-Diode 10 parallel zu Gate G und Source S des MOSFET 6 geschaltet. Beispielsweise kann die Zener-Diode 10 hierzu eine Durchbruchspannung von 12 V aufweisen.

Als Maßnahme zur Verbesserung der elektromagnetischen Verträglichkeit ist ein Kondensator 18 mit einer geringen Kapazität von beispielsweise 1 nF vorgesehen. Dieser Kondensator 18 bewirkt eine Unterdrückung bzw. einen Schutz vor hochfrequenten Störsignalen, wie sie beispielsweise von Mobiltelefonen ausgehen können. Derlei Störsignale könnten sonst ein hochfrequentes Schalten des Gates G bzw. des MOSFET 6 verursachen.

Wenn nun die Spannung am Eingang des MOSFET 6 größer als eine Schwellspannung des MOSFET 6 ist, so schaltet der MOSFET 6 durch, womit der Eingang bzw. die Leuchtdiode 13 des Optokopplers 5 kurzgeschlossen ist, sodass die Leuchtdiode 13 nicht mehr leuchtet. Ist die Spannung am Eingang des MOSFET 6 jedoch kleiner als dessen Schwellspannung, so sperrt der MOSFET 6, sodass Strom über den Eingang des Optokopplers 5 fließen kann, wenn der Schutzleiter PE angeschlossen und nicht unterbrochen ist. Die Erkennungsvorrichtung 1 bzw. die Widerstände R4, R5 einerseits und die Widerstände R2, R3 andererseits sind so ausgelegt, dass bei korrekten Erdungsverhältnissen und korrekter Kontaktierung der Sensorfläche durch den Benutzer die an R3 abfallende Spannung so gering ist, dass der MOSFET 6 nicht durchschaltet und somit kein Fehler signalisiert wird.

Berührt der Benutzer jedoch die Sensorfläche mit einem isolierenden Gegenstand, so ist die an R3 abfallende Spannung selbst bei korrekten Erdungsverhältnissen so hoch, dass der MOSFET 6 durchschaltet. Entsprechend leuchtet dann die Leuchtdiode 13 des Optokopplers 5 nicht mehr, und die Steuereinheit 14 registriert einen Fehler.

Über einen, vorzugsweise elektronischen Schalter SW1 kann das Prüfpotential abgeschaltet werden, indem in einer Ein-Stellung des Schalters SW1 der zweite Leiter 9 mit dem Schutzleiter 2 kurzgeschlossen wird. In einer Aus-Stellung des Schalters SW1, die in Fig. 1 eingezeichnet ist, liegt hingegen das Prüfpotential an der Sensorfläche an.

Dabei dient der Schutzwiderstand R5 wie auch der Schutzwiderstand R2 dem Schutz des Benutzers, falls dieser die Sensorfläche kontaktiert. Zudem sorgen die Schutzwiderstände R5, R2 für eine in beiden Schalterstellungen des Schalters SW1 annähernd gleiche Ausgangsimpedanz der Spannungsquelle des Prüfpotentials.

Insbesondere wenn der Schalter SW1 durch die Steuereinheit 14 angesteuert wird, ermöglicht dies einen Selbsttest der gesamten Sensorik. So kann beispielsweise bei Herstellung des Betriebszustands der Erkennungsvorrichtung 1 der Schalter SW1 ausgeschaltet und damit das Prüfpotential an die Sensorfläche angelegt sein. Wird dann die Fehlerüberprüfung durchgeführt, indem der Benutzer die Sensorfläche berührt, und wird kein Fehler detektiert, kann der Schalter SW 1 eingeschaltet und das Prüfpotential ausgeschaltet werden.

Sodann kann während des Betriebs in regelmäßigen Abständen - von Millisekunden bis Stunden ist prinzipiell alles möglich - der Schalter SW1 kurz aus- und wieder eingeschaltet werden. Sollte dann, ohne dass der Benutzer die Sensorfläche berührt, trotz ausgeschaltetem Schalter SW1 der MOSFET 6 nicht durchschalten, zeigt dies einen Fehler an. Ein solcher Fehler könnte beispielsweise durch einen defekten MOSFET 6 verursacht werden, der immer sperrt.

Prinzipiell könnte die Erkennungsvorrichtung 1 lediglich zur Anzeige bzw. Signalisierung eines Fehlers - sei es ein Fehlerzustand im Zusammenhang mit dem Schutzleiter PE bzw. dem Schutzleiter 2 oder ein Fehler in der Sensorik - benutzt werden, wobei elektrische Betriebsmittel über weiterführende Anschlüsse 19 an der Erkennungsvorrichtung 1, wie sie in Fig. 1 dargestellt sind, mit Spannung versorgt werden.

Die Information, dass ein Fehler vorliegt, kann aber natürlich auch dazu benutzt werden, die Stromversorgung von elektrischen Betriebsmitteln zu unterbrechen. Zu diesem Zweck kann die erfindungsgemäße Erkennungsvorrichtung 1 z.B. Teil einer Fehlerstromschutzeinrichtung 15 sein, wie sie schematisch in Fig. 2 dargestellt ist. In diesem Fall sind die elektrischen Betriebsmittel über weiterführende Anschlüsse 19 mit Spannung versorgt, welche weiterführenden Anschlüsse 19 mit einem allpoligen Schalter - im gezeigten Ausführungsbeispiel einem dreipoligen Schalter 23 - elektrisch verbunden sind.

Der dreipolige Schalter 23 wiederum ist elektrisch mit dem Schutzleiter PE, dem Nullleiter N und dem Phasenleiter L des Niederspannungsnetzes verbunden, wobei ein Summenstromwandler 22 dazwischen geschaltet ist. Die erfindungsgemäße Erkennungsvorrichtung 1 ist eingangsseitig ebenfalls mit dem Schutzleiter PE, dem Nullleiter N und dem Phasenleiter L des Niederspannungsnetzes verbunden, um wie oben beschrieben Fehlerzustände des Schutzleiters PE detektieren zu können. Aus Gründen der Einfachheit ist dabei in Fig. 2 nicht für jeden Leiter L/N/PE eine separate Leitung eingezeichnet, sondern symbolisch nur eine Leitung, die mit der Erkennungsvorrichtung 1 verbunden ist bzw. die den Summenstromwandler 22 mit dem Schalter 23 verbindet.

Zur Detektion der Fehlerzustände des Schutzleiters PE weist die Steuereinheit 14 einen Eingang 30 auf, über den die Signale des Fototransistors 16 des Optokopplers 5 in die Steuereinheit 14 eingespeist werden können, wie bei der Beschreibung von Fig. 1 bereits ausgeführt wurde.

Weiters weist die Steuereinheit 14 im Ausführungsbeispiel der Fig. 2 auch einen Eingang 29 zur Überwachung der Einschalttaste 17 auf. D.h. der Steuereinheit 14 liegt die Information vor, ob sich die Einschalttaste 17 in einer Ein- oder Aus-Position befindet.

Die Information aus den Eingängen 29 und 30 wird von der Steuereinheit 14 ausgewertet. Im Falle eines Fehlerzustands, d.h. wenn der Schutzleiter PE unterbrochen ist oder an diesem eine über einem definierten Grenzwert liegende Fehlerspannung anliegt und/oder wenn die Einschalttaste 17 bzw. der Sensor 7 vom Benutzer mit einem isolierenden Gegenstand betätigt wird und/oder wenn die Sensorik nicht einwandfrei funktioniert, steuert die Steuereinheit 14 den Schalter 23 über den Ausgang 28 an und schaltet diesen aus bzw. verhindert ein Einschalten des Schalters 23. Über die weiterführenden Anschlüsse 19 steht dann keine Spannung zur Verfügung.

Darüberhinaus wird im Ausführungsbeispiel der Fig. 2 die Steuereinheit 14 auch zur Detektion eines Fehlerstroms verwendet. Hierzu weist die Steuereinheit 14 einen Eingang 26 für einen vom Summenstromwandler 22 kommenden Sekundärstrom auf. Dieser ist proportional zu einem Differenzstrom zwischen Phasenleiter L und Nullleiter N. Liegt der Differenzstrom bzw. der Sekundärstrom über einem definierten Grenzwert, so steuert die Steuereinheit 14 den Schalter 23 über den Ausgang 28 an und schaltet diesen aus bzw. verhindert ein Einschalten des Schalters 23. Über die weiterführenden Anschlüsse 19 steht dann keine Spannung zur Verfügung.

Um die Funktionsfähigkeit des Summenstromwandlers 22 überprüfen zu können, weist die Steuereinheit 14 einen Ausgang 27 auf, über welchen dem Summenstromwandler 22 ein Prüfstrom zugeführt werden kann, der über dem für den Differenzstrom definierten Grenzwert liegt. Bei funktionstüchtigem Summenstromwandler 22 muss dieser einen entsprechen hohen Sekundärstrom liefern, der über den Eingang 26 von der Steuereinheit 14 detektiert wird, woraufhin ein Fehlerzustand durch die Steuereinheit 14 erkannt wird und vorzugsweise der Schalter 23 ausgeschaltet wird bzw. ein Einschalten des Schalters 23 unterbunden wird.

Dabei kann mittels der Steuereinheit 14 weiters das Übertragungsmaß überprüft werden, indem der Prüfstrom sehr genau auf einen gewissen Wert eingestellt und der sich ergebende Sekundärstrom genau gemessen wird. Liegt der Sekundärstrom dann nicht in einem bestimmten Intervall, welches sich aus einem gewünschten Übertragungsmaß ergibt, so kann dies von der Steuereinheit 14 ebenfalls als Fehlerzustand interpretiert werden und kann vorzugsweise der Schalter 23 ausgeschaltet bzw. ein Einschalten des Schalters 23 unterbunden werden.

Um den Prüfstrom zur Verfügung stellen zu können, ist über das Niederspannungsnetz eine Stromversorgung 25 der Steuereinheit 14 vorgesehen, wobei aus Gründen der Übersichtlichkeit in Fig. 2 symbolisch nur eine Leitung der Stromversorgung 25 eingezeichnet ist.

Schließlich ist eine Statusanzeige vorgesehen, um den von der Steuereinheit 14 festgestellten Zustand anzuzeigen. Im einfachsten Fall kann dies beispielsweise mittels einer Leuchtdiode 24 erfolgen, die lediglich anzeigt, ob irgendein Fehler vorliegt oder nicht.

### BEZUGSZEICHENLISTE

- 1: Erkennungsvorrichtung
- 2: Schutzleiter der Erkennungsvorrichtung
- 3: Phasenleiter der Erkennungsvorrichtung
- 4: Nullleiter der Erkennungsvorrichtung
- 5: Optokoppler
- 6: MOSFET
- 7: Sensor
- 8: Erster Leiter
- 9: Zweiter Leiter
- 10: Zener-Diode
- 11: Anschlusspunkt für den ersten Leiter
- 12: Anschlusspunkt für den zweiten Leiter
- 13: LED des Optokopplers
- 14: Steuereinheit
- 15: Fehlerstromschutzeinrichtung
- 16: Fototransistor des Optokopplers
- 17: Einschalttaste
- 18: Kondensator
- 19: Weiterführender Anschluss
- 20: Vorwiderstand für den Fototransistor des Optokopplers
- 21: Anschluss für die Spannungsversorgung für den Fototransistors des Optokopplers
- 22: Summenstromwandler
- 23: Dreipoliger Schalter
- 24: Statusanzeige der Steuereinheit
- 25: Stromversorgung der Steuereinheit
- 26: Eingang der Steuereinheit für einen Differenzstrom vom Summenstromwandler
- 27: Ausgang der Steuereinheit für einen Prüfstrom zum Summenstromwandler
- 28: Ausgang der Steuereinheit für die Ansteuerung des dreipoligen Schalters
- 29: Eingang der Steuereinheit für die Überwachung des Zustands der Einschalttaste
- 30: Eingang der Steuereinheit für die Erkennung eines Fehlerzustands des PE-Leiters
- 31: Referenzpotential
- L: Phasenleiter eines Niederspannungsnetzes
- N: Nullleiter des Niederspannungsnetzes
- PE: Schutzleiter des Niederspannungsnetzes
- R1: Vorwiderstand zur Bildung einer ersten Spannungsquelle
- R2: Schutzwiderstand für einen weiteren Spannungsteiler
- R3: Ausgang des weiteren Spannungsteilers
- R4: Weiterer Vorwiderstand zur Bildung einer zweiten Spannungsquelle
- R5: Weiterer Schutzwiderstand
- SW1: Schalter
- G: Gate des MOSFET
- D: Drain des MOSFET
- S: Source des MOSFET

## Patentansprüche

1. Erkennungsvorrichtung (1) zur Erkennung von Fehlerzuständen eines Schutzleiters (PE) eines Niederspannungsnetzes, die Erkennungsvorrichtung (1) umfassend einen Schutzleiter (2) zur Verbindung mit dem Schutzleiter (PE) des Niederspannungsnetzes, wobei in einem Betriebszustand der Erkennungsvorrichtung (1) deren Schutzleiter (2) mit dem Schutzleiter (PE) des Niederspannungsnetzes verbunden ist, wobei die Erkennungsvorrichtung (1) einen ersten Leiter (8) aufweist, um im Betriebszustand zwischen dem ersten Leiter (8) und dem Schutzleiter (2) der Erkennungsvorrichtung (1) eine erste Spannung zur Verfügung zu stellen, wobei die Erkennungsvorrichtung (1) einen Halbleiterschalter (6) aufweist, der zwischen dem ersten Leiter (8) und dem Schutzleiter (2) der Erkennungsvorrichtung (1) so geschaltet ist, dass beim Durchschalten des Halbleiterschalters (6) Strom gegen den Schutzleiter (2) abfließen kann, wobei die Erkennungsvorrichtung (1) weiters einen Sensor (7) mit einer Sensorfläche aus leitfähigem Material zur Berührung durch einen Benutzer aufweist, wobei der Sensor mit einer Steuerelektrode (G) des Halbleiterschalters (6) verbunden ist, **dadurch gekennzeichnet, dass** die Erkennungsvorrichtung (1) einen zweiten Leiter (9) aufweist, der mit der Sensorfläche verbunden ist, um im Betriebszustand an die Sensorfläche ein Prüfpotential anzulegen, um bei Berührung der Sensorfläche durch den auf einem lokalen Erdpotential befindlichen Benutzer einen Spannungsteiler zu bilden, dessen Ausgang eine Impedanz des Benutzers umfasst und mit der Steuerelektrode (G) des Halbleiterschalters (6) verbunden ist, und dass die Erkennungsvorrichtung (1) derart ausgelegt ist, dass im Betriebszustand und bei angelegtem Prüfpotential bei Berührung der Sensorfläche mit einem isolierenden Gegenstand und/oder bei Berührung der Sensorfläche und Vorliegen einer Fehlerspannung, insbesondere Phasenspannung, am Schutzleiter (PE) des Niederspannungsnetzes eine zwischen der Steuerelektrode (G) des Halbleiterschalters (6) und dem Schutzleiter (2) der Erkennungsvorrichtung (1) anliegende Spannung den Halbleiterschalter (6) schaltet, um die Berührung der Sensorfläche mit dem isolierenden Gegenstand und/oder die Fehlerspannung, insbesondere Phasenspannung, am Schutzleiter (PE) des Niederspannungsnetzes als Fehlerzustände erkennen zu können.

2. Erkennungsvorrichtung (1) nach Anspruch 1, **dadurch gekennzeichnet, dass** zur Verbindung des Ausgangs des Spannungsteilers mit der Steuerelektrode (G) des Halbleiterschalters (6) ein weiterer Spannungsteiler (R2, R3) vorgesehen ist, dessen Ausgang mit der Steuerelektrode (G) des Halbleiterschalters (6) verbunden ist.

3. Erkennungsvorrichtung (1) nach einem der Ansprüche 1 bis **2, dadurch gekennzeichnet, dass** zwischen der Steuerelektrode (G) des Halbleiterschalters (6) und dem Schutzleiter (2) der Erkennungsvorrichtung (1) eine Zener-Diode (10) geschaltet ist.

4. Erkennungsvorrichtung (1) nach einem der Ansprüche 1 bis 3, **dadurch gekennzeichnet, dass** die Erkennungsvorrichtung (1) einen Phasenleiter (3) zur Verbindung mit einem Phasenleiter (L) des Niederspannungsnetzes sowie einen Nullleiter (4) zur Verbindung mit einem Nullleiter (N) des Niederspannungsnetzes aufweist, wobei im Betriebszustand der Erkennungsvorrichtung (1) deren Phasenleiter (3) mit dem Phasenleiter (L) oder dem Nullleiter (N) des Niederspannungsnetzes verbunden ist und der Nullleiter (4) der Erkennungsvorrichtung (1) mit dem Nullleiter (N) oder dem Phasenleiter (L) des Niederspannungsnetzes, dass weiters zwischen dem Phasenleiter (2) der Erkennungsvorrichtung (1) und dem Nullleiter (4) der Erkennungsvorrichtung (1) mindestens zwei Widerstände (R1) in Serie geschaltet sind und dass der erste Leiter (8) mit einem Punkt (11) zwischen den mindestens zwei Widerständen (R1) verbunden ist.

5. Erkennungsvorrichtung (1) nach einem der Ansprüche 1 bis 4, **dadurch gekennzeichnet, dass** die Erkennungsvorrichtung (1) einen Phasenleiter (3) zur Verbindung mit einem Phasenleiter (L) des Niederspannungsnetzes sowie einen Nullleiter (4) zur Verbindung mit einem Nullleiter (N) des Niederspannungsnetzes aufweist, wobei im Betriebszustand der Erkennungsvorrichtung (1) deren Phasenleiter (3) mit dem Phasenleiter (L) oder dem Nullleiter (N) des Niederspannungsnetzes verbunden ist und der Nullleiter (4) der Erkennungsvorrichtung (1) mit dem Nullleiter (N) oder dem Phasenleiter (L) des Niederspannungsnetzes, dass weiters zwischen dem Phasenleiter (2) der Erkennungsvorrichtung (1) und dem Nullleiter (4) der Erkennungsvorrichtung (1) mindestens zwei weitere Widerstände (R4) in Serie geschaltet sind und dass der zweite Leiter (9) mit einem Punkt (12) zwischen den mindestens zwei weiteren Widerständen (R4) verbunden ist.

6. Erkennungsvorrichtung (1) nach einem der Ansprüche 1 bis 5, **dadurch gekennzeichnet, dass** die Erkennungsvorrichtung (1) eine Potentialtrennstufe (5) aufweist, deren Eingang parallel zum Halbleiterschalter (6) geschaltet ist.

7. Erkennungsvorrichtung (1) nach Anspruch 6, **dadurch gekennzeichnet, dass** die Potentialtrennstufe ein Optokoppler (5) ist.

8. Erkennungsvorrichtung (1) nach einem der Ansprüche 1 bis 7, **dadurch gekennzeichnet, dass** ein Schalter (SW1) mit dem zweiten Leiter (9) und dem Schutzleiter (2) der Erkennungsvorrichtung (1) verbunden ist, um im Betriebszustand durch Ein-/Ausschalten des Schalters (SW1) den zweiten Leiter (9) mit dem Schutzleiter (2) der Erkennungsvorrichtung (1) kurzzuschließen / den Kurzschluss aufzuheben, um das Prüfpotential aus- /einzuschalten und somit die Funktion der Erkennungsvorrichtung (1) überprüfen zu können.

9. Erkennungsvorrichtung (1) nach einem der Ansprüche 1 bis 8, **dadurch gekennzeichnet, dass** eine Steuereinheit (14) vorgesehen ist, die eingangsseitig mit dem Ausgang der Potentialtrennstufe (5) verbunden ist.

10. Erkennungsvorrichtung nach Anspruch 9, sofern abhängig von Anspruch 8, **dadurch gekennzeichnet, dass** die Steuereinheit (14) mit dem Schalter (SW1) verbunden ist und dieser mit der Steuereinheit (14) steuerbar ist.

11. Verfahren zur Erkennung von Fehlerzuständen eines Schutzleiters (PE), vorzugsweise eines Niederspannungsnetzes, das Verfahren umfassend das Verbinden eines Halbleiterschalters (6) mit dem Schutzleiter (PE), **dadurch gekennzeichnet, dass** das Verfahren die folgenden Schritte umfasst:
- Anlegen eines Prüfpotentials an eine leitende Sensorfläche eines Sensors (7), der mit einer Steuerelektrode (G) des Halbleiterschalters (6) verbunden ist;
- Berührung der Sensorfläche durch einen auf einem lokalen Erdpotential befindlichen Benutzer, wobei ein Spannungsteiler gebildet wird, dessen Ausgang eine Impedanz des Benutzers umfasst und mit der Steuerelektrode (G) des Halbleiterschalters (6) verbunden ist;
- Detektion, ob die Berührung der Sensorfläche mit einem isolierenden Gegenstand erfolgt und/oder ob bei der Berührung der Sensorfläche eine Fehlerspannung, insbesondere Phasenspannung, am Schutzleiter (PE) anliegt, indem detektiert wird, ob der Halbleiterschalter (6) schaltet.

12. Verfahren nach Anspruch 11, **dadurch gekennzeichnet, dass** an den Halbleiterschalter (6) eine erste Spannung angelegt wird, um einen gegen den Schutzleiter (PE) abfließenden Strom zu erzeugen, wenn der Halbleiterschalter (6) durchschaltet.

13. Verfahren nach Anspruch 12, **dadurch gekennzeichnet, dass** zur Detektion, ob der Halbleiter (6) durchschaltet oder nicht, eine Potentialtrennstufe (5) verwendet wird, deren Eingang parallel zum Halbleiterschalter (6) geschaltet ist und kurzgeschlossen wird, wenn der Halbleiterschalter (6) durchschaltet.

14. Verfahren nach Anspruch 13, **dadurch gekennzeichnet, dass** mittels der Potentialtrennstufe (5) außerdem detektiert wird, ob der Schutzleiter (PE) nicht verbunden oder unterbrochen ist, indem bei ausgeschaltetem Prüfpotential detektiert wird, dass über den Eingang der Potentialtrennstufe (5) kein Strom zum Schutzleiter (PE) abfließt.

15. Verfahren nach einem der Ansprüche 11 bis 14, **dadurch gekennzeichnet, dass** eine zur Ansteuerung der Steuerelektrode (G) des Halbleiterschalters (6) verwendete Spannung gegenüber einer Spannung am Ausgang des Spannungsteilers reduziert wird, vorzugsweise mittels eines weiteren Spannungsteilers (R2, R3), dessen Ausgang mit der Steuerelektrode (G) des Halbleiterschalters (6) verbunden ist.

## Claims

1. A detection apparatus (1) for recognising fault states of a protective conductor (PE) of a low-voltage network, the detection apparatus (1) comprising a protective conductor (2) for connection with the protective conductor (PE) of the low-voltage network, wherein, in an operating state of the detection apparatus (1), its protective conductor (2) is connected to the protective conductor (PE) of the low-voltage network, wherein the detection apparatus (1) comprises a first conductor (8) in order to provide a first voltage in the operating state between the first conductor (8) and the protective conductor (2) of the detection apparatus (1), wherein the detection apparatus (1) comprises a semiconductor switch (6) which is switched between the first conductor (8) and the protective conductor (2) of the detection apparatus (1) in such a way that current can flow off against the protective conductor (2) in through-switching of the semiconductor switch (6), wherein the detection apparatus (1) further comprises a sensor (7) with a sensor surface made of conductive material for contact by a user, wherein the sensor is connected to a control electrode (G) of the semiconductor switch (6), **characterized in that** the detection apparatus (1) comprises a second conductor (9) which is connected to the sensor surface in order to apply a test potential to the sensor surface in the operating state in order to form a voltage divider upon contact of the sensor surface by the user situated on a local ground potential, whose output comprises an impedance of the user and is connected to the control electrode (G) of the semiconductor switch (6), and the detection apparatus (1) is designed in such a way that a voltage applied between the control electrode (G) of the semiconductor switch (6) and the protective conductor (2) of the detection apparatus (1) switches the semiconductor switch (6) in the operating state and with applied test potential upon contact of the sensor surface with an insulating object and/or upon contact of the sensor surface and occurrence of a fault voltage, especially phase voltage, on the protective conductor (PE) of the low-voltage network in order to enable recognising the contact of the sensor surface with the insulating object and/or the fault voltage, especially phase voltage, on the protective conductor (PE) of the low-voltage network as fault states.

2. A detection apparatus (1) according to claim 1, **characterized in that** for connecting the output of the voltage divider to the control electrode (G) of the semiconductor switch (6) a further voltage divider (R2, R3) is provided whose output is connected to the control electrode (G) of the semiconductor switch (6).

3. A detection apparatus (1) according to one of the claims 1 to 2, **characterized in that** a zener diode (10) is switched between the control electrode (G) of the semiconductor switch (6) and the protective conductor (2) of the detection apparatus (1).

4. A detection apparatus (1) according to one of the claims 1 to 3, **characterized in that** the detection apparatus (1) comprises a phase conductor (3) for connection with a phase conductor (L) of the low-voltage network and a neutral conductor (4) for connection with a neutral conductor (N) of the low-voltage network, wherein in the operating state of the detection apparatus (1) its phase conductor (3) is connected to the phase conductor (L) or the neutral conductor (N) of the low-voltage network, and the neutral conductor (4) of the detection apparatus (1) to the neutral conductor (N) or the phase conductor (L) of the low-voltage network, at least two resistors (R1) are further switched in series between the phase conductor (2) of the detection apparatus (1) and the neutral conductor (4) of the detection apparatus (1), and the first conductor (8) is connected to a point (11) between the at least two resistors (R1).

5. A detection apparatus (1) according to one of the claims 1 to 4, **characterized in that** the detection apparatus (1) comprises a phase conductor (3) for connection with a phase conductor (L) of the low-voltage network and a neutral conductor (4) for connection with a neutral conductor (N) of the low-voltage network, wherein in the operating state of the detection apparatus (1) its phase conductor (3) is connected to the phase conductor (L) or the neutral conductor (N) of the low-voltage network, and the neutral conductor (4) of detection apparatus (1) is connected to the neutral conductor (N) or the phase conductor (L) of the low-voltage network, at least two further resistors (R4) are further switched in series between the phase conductor (2) of the detection apparatus (1) and the neutral conductor (4) of the detection apparatus (1), and the second conductor (9) is connected to a point (12) between the at least two further resistors (R4).

6. A detection apparatus (1) according to one of the claims 1 to 5, **characterized in that** detection apparatus (1) comprises a potential separation stage (5) whose input is switched in parallel to the semiconductor switch (6).

7. A detection apparatus (1) according to claim 6, **characterized in that** the potential separation stage is an optical coupler (5).

8. A detection apparatus (1) according to one of the claims 1 to 7, **characterized in that** a switch (SW1) is connected to the second conductor (9) and the protective conductor (2) of the detection apparatus (1) in order to short-circuit in the operating state the second conductor (9) with the protective conductor (2) of the detection apparatus (1) / to lift the short-circuit by activating/deactivating the switch (SW1) in order to deactivate/activate the test potential and thus to check the function of the detection apparatus (1).

9. A detection apparatus (1) according to one of the claims 1 to 8, **characterized in that** a control unit (14) is provided, which on the input side is connected to the output of the potential separation stage (5).

10. A detection apparatus (1) according to claim 9, if dependent on claim 8, **characterized in that** the control unit (14) is connected to the switch (SW1) and said switch is controllable by the control unit (14).

11. A method for recognising fault states of a protective conductor (PE), preferably of a low-voltage network, with the method comprising the connection of a semiconductor switch (6) with the protective conductor (PE), **characterized in that** the method comprises the following steps:
- applying a test potential to a conductive sensor surface of a sensor (7) which is connected to a control electrode (G) of the semiconductor switch (6);
- touching the sensor surface by a user disposed on a local ground potential, wherein a voltage divider is formed whose output comprises an impedance of the user and is connected to the control electrode (G) of the semiconductor switch (6);
- detecting whether the contact of the sensor surface has occurred with an insulating object and/or whether in contact with the sensor surface a fault voltage, especially a phase voltage, is applied to the protective conductor (PE), **in that** it is detected whether the semiconductor switch (6) switches.

12. A method according to claim 11, **characterized in that** a first voltage is applied to the semiconductor switch (6) in order to generate a current flowing off against the protective conductor (PE) when the semiconductor switch (6) switches through.

13. A method according to claim 12, **characterized in that** a potential separation stage (5) is used for detecting whether or not the semiconductor switch (6) switches through, whose input is switched in parallel to the semiconductor switch (6) and is short-circuited when the semiconductor switch (6) switches through.

14. A method according to claim 13, **characterized in that** it is also detected by means of the potential separation stage (5) whether the protective conductor (PE) is not connected or interrupted, **in that** it is detected when the test potential is deactivated that no current flows to the protective conductor (PE) via the input of the potential separation stage (5).

15. A method according to one of the claims 11 to 14, **characterized in that** a voltage used for triggering the control electrode (G) of the semiconductor switch (6) is reduced in relation to a voltage at the output of the voltage divider, preferably by means of a further voltage divider (R2, R3) whose output is connected to the control electrode (G) of the semiconductor switch (6).

## Revendications

1. Dispositif de reconnaissance (1) pour reconnaître des états de défaut d'un conducteur de protection (PE) d'un réseau à basse tension, lequel dispositif de reconnaissance (1) comprend un conducteur de protection (2) pour la connexion au conducteur de protection (PE) du réseau à basse tension, dans lequel, dans un état de fonctionnement du dispositif de reconnaissance (1), le conducteur de protection (2) est connecté au conducteur de protection (PE) du réseau à basse tension, dans lequel le dispositif de reconnaissance (1) présente un premier conducteur (8) pour fournir une première tension dans l'état de fonctionnement entre le premier conducteur (8) et le conducteur de protection (2) du dispositif de reconnaissance (1), dans lequel le dispositif de reconnaissance (1) présente un commutateur à semi-conducteurs (6) qui est monté entre le premier conducteur (8) et le conducteur de protection (2) du dispositif de reconnaissance (1), de telle manière que lors de la commutation du commutateur à semi-conducteurs (6), le courant puisse circuler vers le conducteur de protection (2), dans lequel le dispositif de reconnaissance (1) comprend en outre un capteur (7) avec une surface de capteur en matériau conducteur destinée à être touchée par un utilisateur, lequel capteur est connecté à une électrode de commande (G) du commutateur à semi-conducteurs (6), **caractérisé en ce que** le dispositif de reconnaissance (1) présente un deuxième conducteur (9) qui est connecté à la surface de capteur afin d'appliquer un potentiel de test à la surface de capteur dans l'état de fonctionnement afin de former, lorsqu'un utilisateur qui se trouve au potentiel de terre local touche la surface de capteur, un diviseur de tension dont la sortie inclut une impédance de l'utilisateur, et qui est connecté à l'électrode de commande (G) du commutateur à semi-conducteurs (6), et **en ce que** le dispositif de reconnaissance (1) est dimensionné de telle sorte que dans l'état de fonctionnement et avec le potentiel de test appliqué, lorsque la surface de capteur est touchée avec un objet isolant et/ou lorsque la surface de tension est touchée et qu'une tension de défaut est présente, en particulier une tension de phase, sur le conducteur de protection (PE) du réseau à basse tension, une tension présente entre l'électrode de commande (G) du commutateur à semi-conducteurs (6) et le conducteur de protection (2) du dispositif de reconnaissance (1) fait commuter le commutateur à semi-conducteurs (6) afin de pouvoir détecter le contact de la surface de capteur avec l'objet isolant et/ou la tension de défaut, en particulier la tension de phase, sur le conducteur de protection (PE) du réseau à basse tension comme des états de défaut.

2. Dispositif de reconnaissance (1) selon la revendication 1, **caractérisé en ce qu'**il est prévu, pour connecter la sortie du diviseur de tension à l'électrode de commande (G) du commutateur à semi-conducteurs (6), un autre diviseur de tension (R2, R3) dont la sortie est connectée à l'électrode de commande (G) du commutateur à semi-conducteurs (6).

3. Dispositif de reconnaissance (1) selon l'une des revendications 1 à 2, **caractérisé en ce qu'**une diode Zener (10) est montée entre l'électrode de commande (G) du commutateur à semi-conducteurs (6) et le conducteur de protection (2) du dispositif de reconnaissance (1).

4. Dispositif de reconnaissance (1) selon l'une des revendications 1 à 3, **caractérisé en ce que** le dispositif de reconnaissance (1) comprend un conducteur de phase (3) à connecter à un conducteur de phase (L) du réseau à basse tension et un conducteur neutre (4) à connecter à un conducteur neutre (N) du réseau à basse tension, le conducteur de phase (3) du dispositif de reconnaissance (1) étant connecté au conducteur de phase (L) ou au conducteur neutre (N) du réseau à basse tension dans l'état de fonctionnement et le conducteur neutre (4) du dispositif de reconnaissance (1) étant connecté au conducteur neutre (N) ou au conducteur de phase (L) du réseau à basse tension, et **en ce qu'**au moins deux résistances (R1) sont montées en série entre le conducteur de phase (2) du dispositif de reconnaissance (1) et le conducteur neutre (4) du dispositif de reconnaissance (1) et **en ce que** le premier conducteur (8) est connecté à un point (11) situé entre les au moins deux résistances (R1).

5. Dispositif de reconnaissance (1) selon l'une des revendications 1 à 4, **caractérisé en ce que** le dispositif de reconnaissance (1) comprend un conducteur de phase (3) à connecter à un conducteur de phase (L) du réseau à basse tension et un conducteur neutre (4) à connecter à un conducteur neutre (N) du réseau à basse tension, le conducteur de phase (3) du dispositif de reconnaissance (1) étant connecté au conducteur de phase (L) ou au conducteur neutre (N) du réseau à basse tension dans l'état de fonctionnement et le conducteur neutre (4) du dispositif de reconnaissance (1) étant connecté au conducteur neutre (N) ou au conducteur de phase (L) du réseau à basse tension, et **en ce qu'**au moins deux autres résistances (R4) sont montées en série entre le conducteur de phase (2) du dispositif de reconnaissance (1) et le conducteur neutre (4) du dispositif de reconnaissance (1) et **en ce que** le deuxième conducteur (9) est connecté à un point (12) situé entre les au moins deux autres résistances (R4).

6. Dispositif de reconnaissance (1) selon l'une des revendications 1 à 5, **caractérisé en ce que** le dispositif de reconnaissance (1) comprend un étage de séparation de potentiel (5) dont l'entrée est montée en parallèle avec le commutateur à semi-conducteurs (6).

7. Dispositif de reconnaissance (1) selon la revendication 6, **caractérisé en ce que** l'étage de séparation de potentiel est un coupleur optique (5).

8. Dispositif de reconnaissance (1) selon l'une des revendications 1 à 7, **caractérisé en ce qu'**un commutateur (SW1) est connecté au deuxième conducteur (9) et au conducteur de protection (2) du dispositif de reconnaissance (1) pour court-circuiter le deuxième conducteur (9) avec le conducteur de protection (2) du dispositif de reconnaissance (1) et défaire le court-circuit dans l'état de fonctionnement en activant et désactivant le commutateur (SW1) afin d'établir et de couper le potentiel de test et de pouvoir ainsi vérifier le fonctionnement du dispositif de reconnaissance (1).

9. Dispositif de reconnaissance (1) selon l'une des revendications 1 à 8, **caractérisé en ce qu'**il est prévu une unité de commande (14) qui est connectée du côté de l'entrée à la sortie de l'étage de séparation de potentiel (5).

10. Dispositif de reconnaissance selon la revendication 9, si celle-ci est dépendante de la revendication 8, **caractérisé en ce que** l'unité de commande (14) est connectée au commutateur (SW1) et celui-ci peut être commandé avec l'unité de commande (14).

11. Procédé pour reconnaître des états de défaut d'un conducteur de protection (PE), de préférence dans un réseau à basse tension, comprenant la connexion d'un commutateur à semi-conducteurs (6) au conducteur de protection (PE), **caractérisé en ce qu'**il comprend les étapes suivantes :
- application d'un potentiel de test à une surface de capteur conductrice d'un capteur (7) qui est connecté à une électrode de commande (G) du commutateur à semi-conducteurs (6) ;
- contact avec la surface de capteur d'un utilisateur qui se trouve à un potentiel de terre local, formant ainsi un diviseur de tension dont la sortie inclut une impédance de l'utilisateur et qui est connecté à l'électrode de commande (G) du commutateur à semi-conducteurs (6) ;
- détection du fait que la surface de capteur est en contact avec un objet isolant et/ou du fait qu'une tension de défaut, en particulier une tension de phase, est présente lors du contact avec le surface de capteur sur le conducteur de protection (PE), en détectant ainsi si le commutateur à semi-conducteurs (6) commute.

12. Procédé selon la revendication 11, **caractérisé en ce qu'**une première tension est appliquée au commutateur à semi-conducteurs (6) pour produire un courant qui circule vers le conducteur de protection (PE) quand le commutateur à semi-conducteurs (6) commute.

13. Procédé selon la revendication 12, **caractérisé en ce que** pour détecter si le commutateur à semi-conducteur (6) commute ou pas, on utilise un étage de séparation de potentiel (5) dont l'entrée est montée en parallèle avec le commutateur à semi-conducteurs (6) et court-circuitée quand le commutateur à semi-conducteurs (6) commute.

14. Procédé selon la revendication 13, **caractérisé en ce que** l'on détecte en outre, au moyen de l'étage de séparation de potentiel (5), si le conducteur de protection (PE) n'est pas connecté ou est coupé, par le fait que lorsque le potentiel de test est coupé, l'absence de passage du courant par l'entrée de l'étage de séparation de potentiel (5) vers le conducteur de protection (PE) est détectée.

15. Procédé selon l'une des revendications 11 à 14, **caractérisé en ce qu'**une tension utilisée pour activer l'électrode de commande (G) du commutateur à semi-conducteurs (6) est réduite par rapport à une tension à la sortie du diviseur de tension, de préférence au moyen d'un autre diviseur de tension (R2, R3) dont la sortie est connectée à l'électrode de commande (G) du commutateur à semi-conducteurs (6).
